# EUROPEAN PATENT APPLICATION

(11) **EP 2 080 570 A1**
(43) Date of publication of application: **22.07.2009**
(21) Application number: 08000936.8
(22) Date of filing: 18.01.2008
(51) Int. Cl.: B21D 28/04, B26F 1/00, B41F 27/00, G03F 9/00

(54) **Printing plates**

(71) Applicant: Rexam Beverage Can Europe Limited, Luton, Bedfordshire LU1 3LG (GB)
(72) Inventor: Billgren, Sven, Vellinge 235 92 (SE); Hopkinson, Christopher Carey, Thurgoland Sheffield S35 7BX (GB)
(74) Representative: Dunlop, Brian Kenneth Charles

(57) **Abstract**

A method of providing registration holes in a workpiece (10) having a defined working area (11) including forming a raised portion (12) on the part of the workpiece not contained within the working area for providing a datum (16) in a first direction and an opening (14) in the raised portion, one wall of the opening providing a datum (15) in a direction orthogonal to the first.

## Description

This invention relates to printing plates and punches for punching location holes in such plates.

Traditionally, printing plates carrying an image to be printed are located on cylinders in a printing machine. The position of the printing plate on the cylinder is critical to allowing the various colours making up the image to be aligned. Many systems employ a series of holes accurately punched in a steel backed plate, which carries the image and these holes are fitted on ground steel pins located on the cylinder. When using conventional photographic films to carry the image from the digital file to the printing plate, the position of these holes is often controlled by punching holes in the film carrying the image and locating the film before exposure on pins positioned in punch holes in the plate. Although these systems are functional, they cannot be employed where the image is transferred directly from the digital file to the printing plate without use of photographic film. Similar registration issues can arise with other workpieces, which having working areas that need to be precisely located.

From one aspect, the present invention comprises a method of providing registration holes in a workpiece having a defined working area including forming a raised portion on the part of the workpiece not contained within the working area for providing a datum in a first direction and an opening in the raised portion, one wall of the opening providing a datum in the direction of orthogonal to the first.

The raised portion may be laser engraved directly from the digital file.

The workpiece may be a printing plate and the working area may be an image to be printed. In this case, the image may be laser engraved from a digital image file. Preferably, the raised portion and the image or working area can be formed simultaneously in this way.

This approach is extremely flexible and is particularly suitable when using direct laser engraving to transfer the image from the digital file to the raised image printing plate because the resulting area has very straight shoulders compared to photographically exposed printing plates. The raised portion can therefore provide extremely accurate datums and the exact position of those datums can be readily adjusted in the digital file to suit any particular printing press or other working machine. To date, alternative methods of punching directly laser engraved plates require the use of complex optical sensors to locate register marks engraved into the plates surface. These systems are typically expensive to build and operate relatively slowly.

The invention also includes a workpiece having a working area and a non-working area, the workpiece having a raised portion for providing a datum in the first direction and an opening in the portion, one wall of the opening providing a datum in a direction orthogonal to the first.

The opening may be generally central in the raised portion. The workpiece may be generally rectangular and the raised portion may extend parallel to an edge thereof. Additionally or alternatively, the working area may be generally rectangular and the raised portion may extend parallel to an edge thereof.
The workpiece may include an area for receiving punched location holes, so punch hole area being spaced from the working area and the raised portion. The workpiece may be a printing plate and the working area may be an image. The image and/or raised portion may be formed by direct laser engraving from a digital file.

From a further aspect, the invention consists in a punch assembly for punching location holes in a workpiece including a bed for receiving the workpiece, a punch extending along a dimension of the bed and a guide extending at an angle to the punch **characterised in that** the guide has a proportion overhanging the bed to define a recess for receiving an edge and to define a datum edge against which a raised portion can engage and having a formation for defining a further datum orthogonal to the datum edge.

The formation may be in the form of a projection and the projection may be located generally centrally of the datum edge.

The invention further includes a method of punching location holes in a workpiece as defined above or formed by a method as set out above including presenting a workpiece to a punch assembly as defined above, such that its raised portion datums engage respective datums on the guide, and punching location holes when the workpiece is so located.

Although the invention has been defined above, it is to be understood it includes any inventive combination of the features set out above or in the following description.

The invention may be performed in various ways and specific embodiments will now be described, by way of example, with reference to the accompanying drawings in which:-
Figure 1 is a plan view of a printing plate;
Figure 2 is a side view of a guide mounted on the base of a punch assembly with a workpiece being placed in registration on the guide;
Figure 3 is a planned view of the guide of Figure 2.
Figure 4 is a photograph from one side and one end of a punch assembly incorporating a guide as illustrated in Figures 2 and 3; and
Figure 5 is a view from one end and above of the punch assembly in figure 4, showing the location of a printing plate.

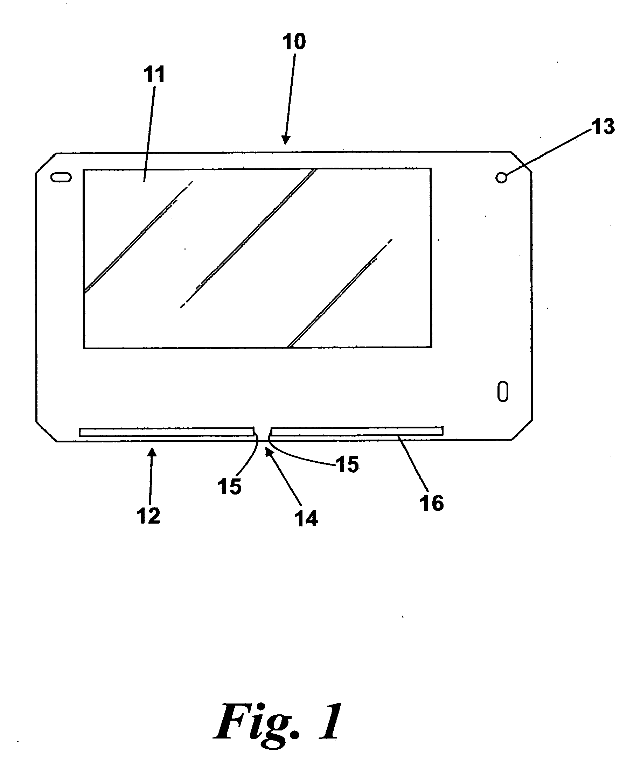

A printing plate 10 is illustrated in Figure 1. The plate 10 is an engraved relief steel backed letter press printing plate, which has an engraved image 11 formed on one part, a raised bar 12 formed on another part. The raised portion 12 consists of a bar extending generally parallel to the image area 11 and an edge of the plate 10. The bar has an opening 14, adjacent at centre, which defines a pair of lateral walls 15. The surface 16 and one of the walls 15 form orthogonal datums, which have positions defined relative to the image area 11.

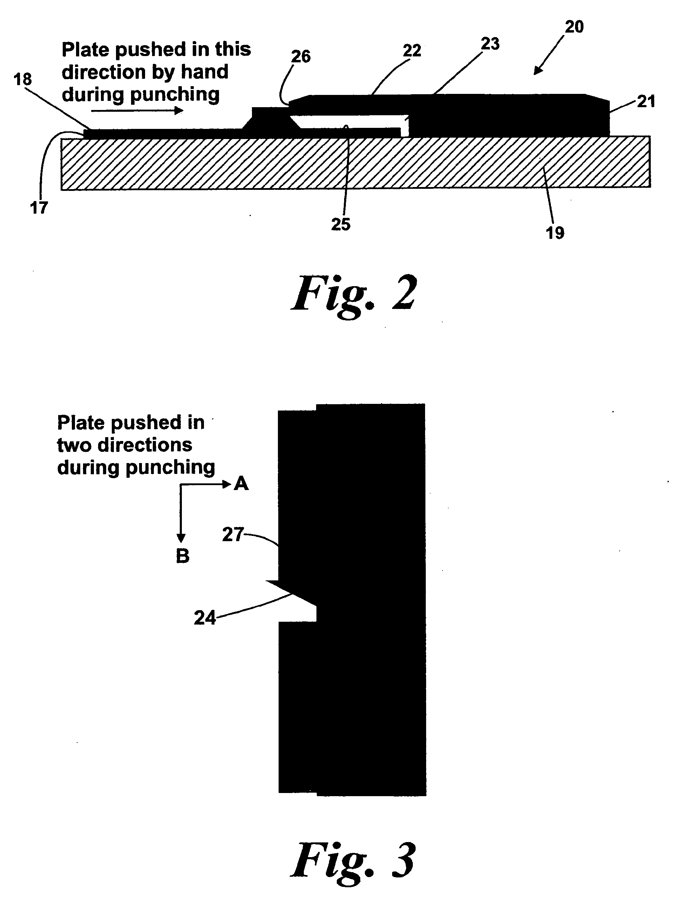

The image in area 11 and the raised portion 12 are formed by direct laser engraving from a digital image file. Typically, the printing plate will consist of a steel backing 17 and a polymer engravable upper portion 18 (see Figure 2). The portion 18 could be made of any suitable material, including metal. The use of laser engraving not only enables the image and raised portion to be formed directly from the digital image file, it also means that the datum surfaces can be formed with great precision.

As can be seen in Figures 2 and 3, the datums 15, 16 can be used to locate the plate 10 precisely in two dimensions, having first been located in the third dimension by a support. This support 19 is provided by the base plate or bed of a punch assembly. A guide 20 is mounted on the bed 19 and consists of a base 21, which is mounted on the bed 19, an overhanging portion 22 that defines a recess 23 below it and a lateral projection 24 that extends out of the overhang portion 22 adjacent centre point of the guide 20. As can be seen in Figures 2 and 3, a plate 10 can be pushed along the bed 19 towards the guide so that an edge portion 25 can enter the recess 23, allowing the datum surface 16 to engage a datum edge 26 of the overhang 22. This will only occur if the projection 24 enters the opening 14. The plate 10 is then moved longitudinally to achieve engagement of a longitudinally facing face 27 of the projection 24 against a wall 15. This is achieved by first moving the plate in the direction of the arrow A and then moving the plate in the direction of the arrow B.
It will be understood that the plate 10 is now located precisely in all three dimensions by means of a very simple handling operation.

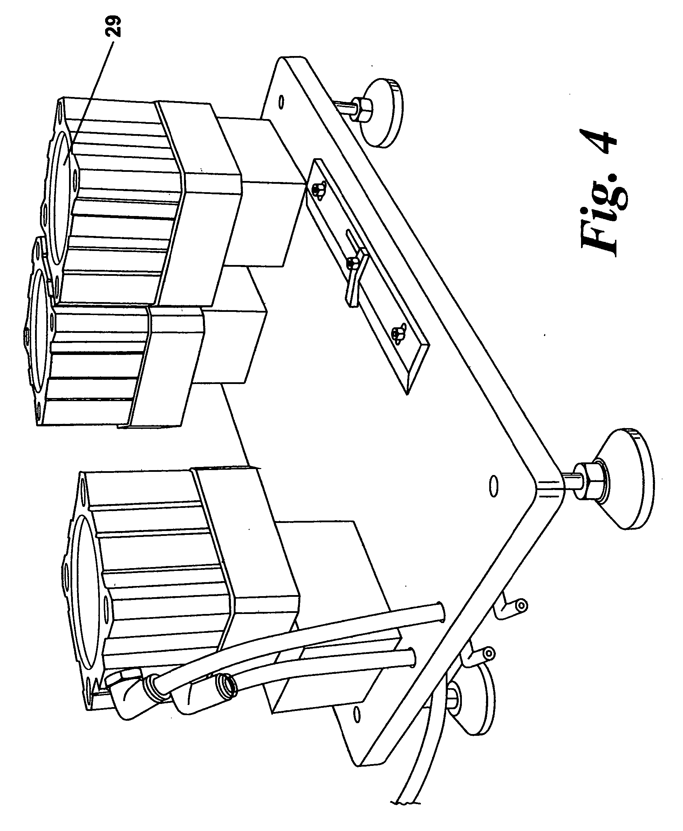

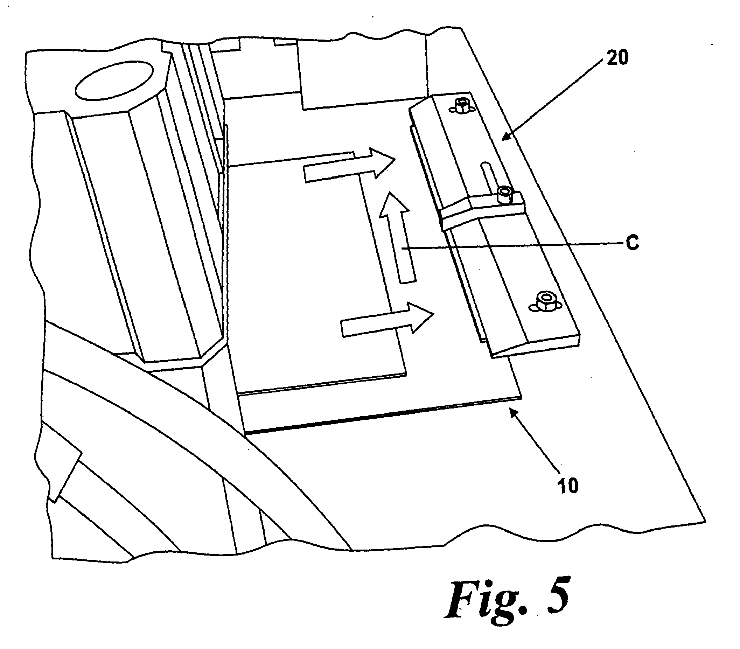

Turning now to Figures 4 and 5, it can be seen that, with this arrangement, the portion 28 of the plate 10 can be inserted into the slot of punch head 29 in a precisely defined position. Accordingly, the punched holes 13 (see Figure 1) will have precisely the intended special relationship with the image 11.

A longitudinal movement arrow C in Figure 5 is the reverse of arrow B shown in Figure 3 because the projection 24 is the other way around.

## Claims

1. A method of providing registration holes in a workpiece having a defined working area including forming a raised portion on the part of the workpiece not contained within the working area for providing a datum in a first direction and an opening in the raised portion, one wall of the opening providing a datum in a direction orthogonal to the first.

2. A method as claimed in Claim 1 wherein the raised portion is laser engraved directly from a digital image file.

3. A method as claimed in Claim 1 wherein the workpiece is a printing plate and the working area is an image.

4. A method as claimed in Claim 3 wherein the image is laser engraved from a digital image file.

5. A workpiece having a working area and a non-working area, the workpiece having a raised portion for providing a datum in a first direction and an opening in the portion, one wall of the opening providing a datum in a direction orthogonal to the first.

6. A workpiece as claimed in Claim 5 wherein the opening is generally central in the raised portion.

7. A plate as claimed in Claim 5 or claim 6 wherein workpiece is generally rectangular and the raised portion extends parallel to an edge thereof.

8. A workpiece as claimed in any one of the preceding claims wherein the working area is rectangular and the raised portion extends generally parallel to an edge thereof.

9. A workpiece as claimed in any one of the preceding claims wherein the workpiece includes an area for receiving punched location holes, said punch hole area being spaced from the working area and the raised portion.

10. A workpiece as claimed in any one of Claims 5 to 9 wherein the workpiece is a printing plate and the working area is an image.

11. A workpiece as claimed in Claim 10 wherein the image and/or the raised portion are formed by laser engraving from a digital file direct.

12. A punch assembly for punching location holes in a workpiece including a bed for receiving the workpiece, a punch extending along a dimension of the bed and a guide extending at angle to the punch **characterised in that** the guide has a portion overhanging the bed to define a recess for receiving an edge of a workpiece and to define a datum edge against which a raised portion can engage and having a formation for defining a further datum orthogonal to the datum edge.

13. A punch assembly as claimed in Claim 12 wherein the formation is in the form of a projection.

14. A punch assembly as claimed in Claim 12 or Claim 13 wherein projection is located generally centrally of the datum edge.

15. A method of punching location holes in a workpiece as claimed in any one of the Claims 5 to 11 or as formed by the method of Claims 1 to 4 including presenting the workpiece to the punch assembly of any one of Claims 12 to 15, such that its raised portion datums engage respective datums on the guide, and punching location holes when the workpiece is so located
